Europäisches Patentamt

European Patent Office

Office européen des brevets

(11) Publication number: **0 079 127**

**A1**

(12) **EUROPEAN PATENT APPLICATION**

(21) Application number: **82305314.5**

(22) Date of filing: **06.10.82**

(51) Int. Cl.³: **G 06 F 9/22**
G 06 F 15/06, H 01 L 27/02

(30) Priority: **06.11.81 US 318725**

(43) Date of publication of application:
**18.05.83 Bulletin 83/20**

(84) Designated Contracting States:
**DE FR GB NL**

(71) Applicant: **TEXAS INSTRUMENTS INCORPORATED**
**13500 North Central Expressway**
**Dallas Texas 75265(US)**

(72) Inventor: **Carpenter, Curtis J.**
**4951 Victor**
**Dallas Texas 75214(US)**

(72) Inventor: **Ray, William B., Jr.**
**908 Wedgewood**
**Richardson Texas 75080(US)**

(74) Representative: **Abbott, David John et al,**
**Abel & Imray Northumberland House 303-306 High**
**Holborn**
**London, WC1V 7LH(GB)**

(54) **Programmable system component.**

(57) A gate array (3) and read only memory (5) are built on a single substrate (1). Propagation delays are minimized with respect to on-chip firmware. The device is programmable to operate as a microprocessor, a peripheral circuit for a digital information processing system, or as a member of a multichip processing system. The device can be programmed to handle varying word widths due to its flexibility.

Fig.1

EP 0 079 127 A1

PROGRAMMABLE SYSTEM COMPONENT

BACKGROUND OF THE INVENTION

In recent years the increased complexity of electronic devices used in digital information processing systems has reduced the size and power requirements of these electronic devices substantially.

One major development has been the recognition of the difference between software, which is instructions to a computer system; and hardware, which is the physical wiring and logical function of the computer system. The additional development of "firmware" which is a computer program or instruction such as a microprogram, used so often that it is stored in a read only memory instead of being included in software, has further enabled the development of more complex systems. Variations include simple systems which are capable of being handled exclusively with hardware, being very fast, or a software controlled and very complex system capable of handling the most difficult problems currently processible. Firmware improves the speed of the system by allowing the encoded program on the ROM to be much more readily available to the processor.

It is recognized that logic in the various technologies of semiconductor development will have finite limitations as to the maximum speed, the maximum density of circuit elements and minimum power dissipations. Therefore, the object of the present invention is to provide an improved digital information processing system, within present technological capabilities.

It is a further object of the present invention to simiplify the manufacturing of the semiconductor devices of relatively complex technologies by eliminating processing steps.

It is a still further object of the present invention to provide a faster digital information processing system with improved operating characteristics.

Yet a further object of the present invention is to

2

provide a digital information processing system of considerable complexity which is capable of being produced in a shortened period of time from the time of final circuit definition due to the nature of the device.

## SUMMARY AND BRIEF DESCRIPTION OF THE DRAWINGS

In accordance with the present invention a programmable digital information processing system is integrated on a single substrate comprising an array of uncommitted gates capable of performing a plurality of logic functions when programmed, and a read only memory interconnected with the gate array for providing control or constants for the system.

Furthermore, in one embodiment, the gates and memory utilize the same metallization and contact opening sequence for gate interconnects and for memory cell programming.

The programmable read only memory is in communication with the gate array and is integrated on the same substrate, to provide a control element for the system in one embodiment.

In another embodiment the memory provides a data reference source of constants for the programmable digital information processing system.

In yet another embodiment the digital information processing circuit is integrated on a single substrate and comprises a gate array region located centrally on the substrate, I/O circuitry located at the periphery of the substrate and at least one region of read only memory located intermediate a portion of the I/O circuitry and said gate array.

The region of read only memory as above in one aspect comprises two spaced memory regions having the gate array region located therebetween.  The circuit further comprises an additional read only memory adjacent the gate array region for providing a data reference source of constants to the circuit.

Additional gate array circuits are located on the chip for providing additional functions.

A programmable digital information system in accordance with the present invention comprises a plurality of integrated circuits, at least one of said circuits having both gate array circuitry and read only memory, and means for electrical interconnection of the circuits.

In a system, as above, the integrated circuits form a complete microprocessor system, each of the circuits cooperating with the system to perform a specific set of functions. In this capacity the programmable system component acts as a peripheral circuit to support a microprocessor based system.

A microprocessor system in another embodiment in accordance with the present invention comprises an integrated circuit having gate array circuitry and read only memory, and peripheral circuitry connected to the circuit providing support functions thereto. In this capacity the programmable system component is the central processing unit of a microprocessor system.

Furthermore, a microprocessor system comprises at least two integrated circuits, each having gate array circuitry and read only memory, said circuits cooperatively interconnected to perform microprocessor functions and means for interconnection to additional circuitry for data input and output. In this capacity, the programmable system component cooperates with additional programmable system components to form a microprocessor chip set.

One embodiment of a programmable digital information processing system on a chip in accordance with the present invention comprises gate array circuitry, input and output circuitry, read only memory wherein the total number of read only memory cells is from three to one hundred times the total number of gates in the gate array, and means for interconnection of the gate array, the memory, and the input and output circuitry.

In another embodiment, a programmable digital information processing circuit is integrated on a single substrate comprising I/O circuitry, at least one region of read only memory adjacent said I/O circuitry and in communication with a portion of said circuitry, and a gate array region located adjacent the read only memory region and in communication with both the memory and a portion of the I/O circuitry.

In yet another embodiment, a programmable digital information processing circuit is integrated on a single substrate comprising I/O circuitry located on the periphery of the substrate, at least one region of gate array located adjacent the I/O circuitry and in communication with a portion of said circuitry, and at least one region of read only memory located centrally with respect to the gate array and in communication with the gate array and a portion of the I/O circuitry.

A method is provided for programming a partially completed digital information processing system in accordance with the present invention wherein the system comprises a plurality of logic gates on a semiconductor and a digital read only memory on at least one region of the semiconductor; the method comprising the steps of forming interconnections between the logic gates, forming interconnections between the gates and the memory, and placing memory data in selected cells of the read only memory cells.

Furthermore, in the above method the gate interconnections, the gate to memory interconnections, and the memory data may be formed concurrently in the same sequence of steps.

Other objects and features of the invention will become more readily understood from the following detailed description when read in conjunction with the appended claims and the accompanying drawings in which:

Figure 1 is a schematic chip layout of a programmable system component in accordance with the present invention. The ROM is shown adjacent the I/O circuitry.

Figure 2 is a schematic chip layout of another embodiment of the present invention, wherein the ROM is shown centrally located with respect to the gate array circuitry.

Figure 3 is a schematic chip layout diagram showing the combination of ROM and gate array in accordance with the present invention, wherein the programmable system component has ROM used as a source of constants for the circuitry and has additional ROM used for the control function of the circuit.

Figure 4 is a block diagram of a multichip microprocessor system wherein various components represented by blocks are supplanted by programmable system components in accordance with the present invention.

### DETAILED DESCRIPTION OF THE DRAWINGS

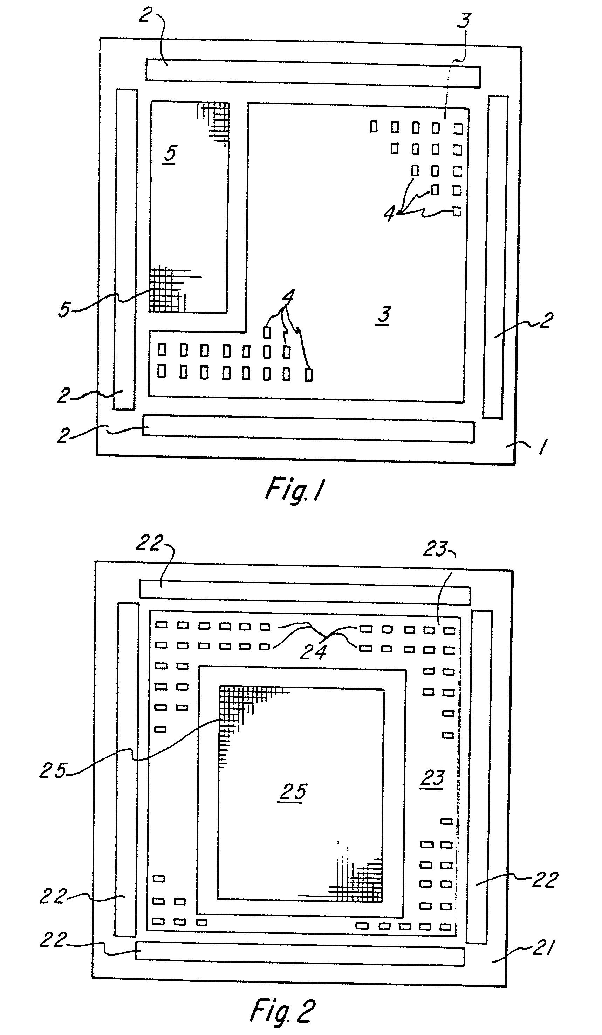

Referring now to Figure 1, a schematic chip layout is shown in accordance with the present invention. A substrate 1 while shown square is not necessarily so and may be of any shape which is conducive to good semiconductor manufacturing practice. Input and output circuitry 2 is shown on the periphery of substrate 1 and contains bonding pads for connecting the chip to the lead frame and additional circuitry. The gate array region 3 is shown generally in the central portion of the chip with individual gates or blocks of gates 4 available to be interconnected to perform desired logic functions. ROM 5 is shown on one side of the chip adjacent to the I/O circuitry and in this configuration provides a convenient interconnection access for the ROM to the I/O circuitry. The ROM will have a plurality of interconnections directly to the I/O circuitry and thus the interconnection scheme is considerably simplified by placing the ROM directly adjacent the I/O circuitry as in Figure 1. In a space array configuration the I/O circuitry is not necessary on the periphery, but is interspersed over the chip surface.

Referring now to Figure 2, a schematic chip layout is shown on substrate 21 having I/O circuitry 22 at the peripheral edges of the substrate. In this embodiment, the ROM 25 is shown centrally placed and surrounded by the gate array region 23. This provides the advantage of extremely short control lines from ROM 25 to the gates or gate blocks 24 and provides for much quicker control than otherwise. The ROM connections to the I/O circuitry will travel through channels between the gate blocks 24.

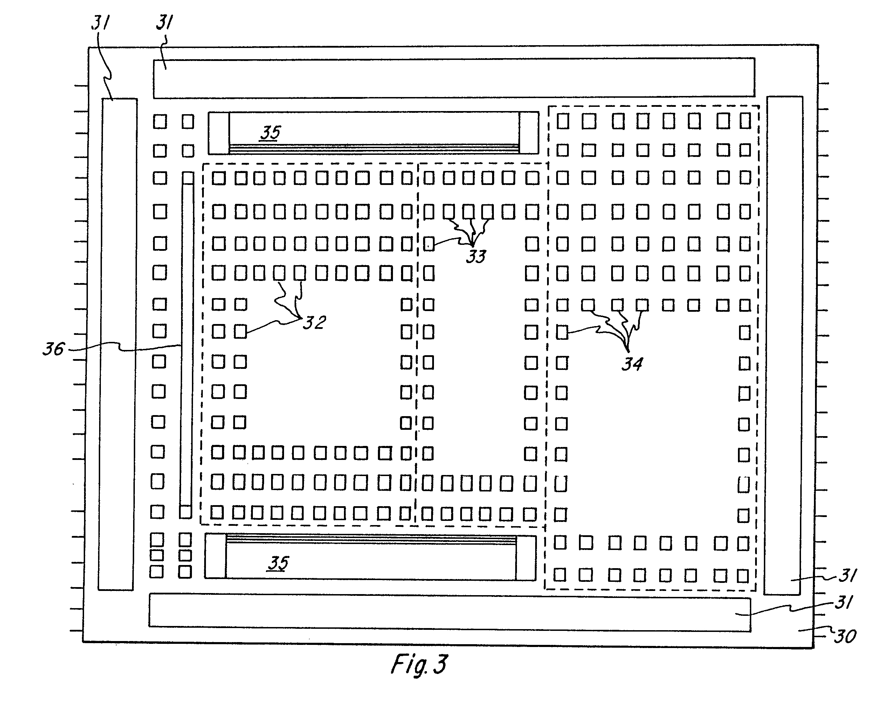

Referring now to Figure 3, a more complex embodiment of the programmable system component, in accordance with the present invention, is shown. Substrate 30 is in an approximate rectangular configuration with I/O circuitry 31 shown at the periphery. ROM sections 35 are shown adjacent I/O circuitry 31 and ROM sections 35 is

utilized for control of the information processing system. ROM 36 is shown essentially surrounded by uncommitted gates. ROM 36 is used as a source of constants for the register section 32 of the uncommitted gates. Section 33 of the gate array is used as an arithmetic logic unit and section 34 of the gate array is used for random logic.

It may be seen from Figure 3 that the ALU section, in this case section 33, may be expanded or contracted for a particular desired purpose. Thus, a partially finished programmable system component is programmed to a customers specific need in accordance with the requirement for a relatively fast but simple logic processor or a relatively complex scientific application requiring extreme accuracy.

Furthermore, the programmable system component is useful as a peripheral in support of a microprocessor system where the PSC may second source any number of dedicated logic units and will be available to the customer on relatively short notice. This semicustom aspect has the advantage of providing the programmable system component with considerable avenues for its use. The PSC may be also used as a complete microprocessor system. In this aspect the user selects the word width, for example - a four bit word microprocessor is implemented on a PSC with very little difficulty while the same unprogrammed PSC is capable of performing 32 bit word microprocessor functions in its programmed state. Thus, the flexibility of having a partially completed programmable system component to operate as a peripheral support chip or as main microprocessor of variable word width may be seen. Furthermore, the use of design automation techniques such as are described in the article by Richard Horton, et al., entitled "Design Automation Speeds Through Customization of Logic Arrays", Electronics, July 14, 1981, p. 132, which is incorporated herein by reference, greatly enhances the flexibility of the P.S.C.

In alternative embodiments the programmable system

9        **0079127**

component may be programmed in conjunction with additional PSC's to form a multichip microprocessor system.

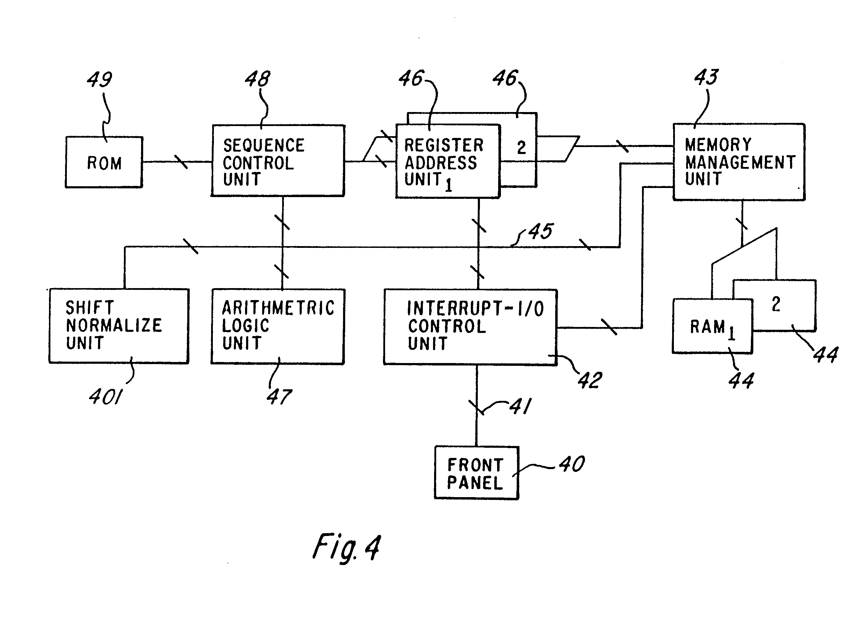

Referring now to Figure 4, a multichip microprocessor system is shown in which the block diagram represents chips and the interconnecting lines represent electrical interconnections between chips in the multichip set. Block 40 is the front panel for operator control. Line 41 represents the multiple connection aspect of the interconnecting lines and is 4, 8, 16, 32, or more lines as required in the microprocessor chip system.

Block 42 is the input and output control unit and is implemented on a programmable system component in one embodiment. It is further connected to block 43 which is the memory management unit which also is implemented on a programmable system component of the same basic architecture as that of block 42 and the memory management unit is further connected to various types of random access memory shown by blocks 44. The memory management unit 43 and the I/O control unit 42 are both connected to main bus 45 and this bus is further connected to register address units 46, the arithmetic logic unit 47, the sequence control unit 48 and the shift normalize unit 401. Each of the blocks 401, 47, 48, 46, are all implemented on programmable system components of the same basic architecture as that of the I/O control and memory management unit. In the alternative, various discrete chips of a dedicated system are temporarily or permanently replaced by programmable system components to support the overall operation of the microprocessor based system. In this manner, the shift normalize unit 401, in one embodiment, is the only programmable system component in a microprocessor system.

In an alternative embodiment, every major computational or processing member of a microprocessor multichip set system comprises a programmable system component.

Thus, it may be seen that with one architecture, a programmable system component has the flexibility to support a variety of customer needs with respect to programmable digital information processing systems and may be implemented as a peripheral support unit, a complete microprocessor system, or as a member of a set of programmable system components to form a multichip microprocessor set.

In programming the PSC, the gate interconnects, the gate to memory connections, and the memory cell data bits are all programmed at the same time by opening contacts and subsequent metalization in any accepted semiconductor manufacturing process. Since the gate interconnects and memory data are programmed at the same time, a partially completed PSC is readily available to implement a design on short notice once the completed logic function and microcode data are finalized. This aspect lends itself particularly well to computer aided design and systems wherein a computer processes a logic function and generates a circuit design for the gate array as well as the microcode required program. In operation the ratio of gates to microcode bits will range from 100 bits of ROM on a chip to each gate of gate array to approximately three bits of microcode for each gate. The range ratio of five bits to one gate is preferable for the most versatile systems, however as the amount of memory increases to approximately 30 to 1 the most efficient system is then attained. For example, a gate array consisting of approximately 10,000 uncommitted gates in conjunction with a 256 K random access memory on the same chip would have improved efficiency, although in actual use subsequent to programming, it is highly probable that only 90% or less of the gates will be actually used.

The article entitled "A 50 KBit Schottky Cell Bipolar Read-Only Memory" by John Ludwig, was published in the IEEE Journal of Solid State Circuits, Vol. SC-15, no. 5, October 1980, and describes in detail how a high density ROM can be constructed. Those construction and design

11

techniques are entirely compatible with the concepts described in the article by George Huffman entitled "Gate Array Logic", and the article by Robert Lipp entitled "Understanding Gate Arrays Ensures Wise Chip Selection", both published in EDN magazine, September 1981, at page 86 and page 99, respectfully. The ROM article and the two gate array articles are incorporated herein by reference.

While the principles of this invention have been described in connection with specific examples, it is to be understood that this description is made only by way of example and not as a limitation to the scope of the invention. The disclosed invention is used as a discrete digital information processing system or as a peripheral support circuit for another broader digital processing system, or is used in conjunction with additional programmable system components as a multichip microprocessor or digital information processing unit. Numerous circuits using this invention may be devised by those skilled in the art. Furthermore, the PSC may be used as a readily available second source for discrete nonprogrammable circuits already in use in a given circuit design. While one embodiment has the advantage of concurrent programming by the use of the same metallization and contact opening sequence for gate interconnects as for the ROM memory bit programming, additional embodiments do not require concurrent programmation capabilities to remain within the scope and spirit of the invention.

WHAT IS CLAIMED IS

1. A programmable digital information processing system integrated on a single substrate, comprising:

     a) a gate array capable of performing a plurality of logic functions when programmed; and

     b) a read only memory interconnected with said gate array for providing control or constants for said system.

2. The system of Claim 1, further comprising:

     means for programming said gates and said memory utilizing the same metallization and contact opening sequence for gate interconnects and for memory cell programming.

3. The system of Claims 1 or 2, further comprising:

     I/O circuitry located at the periphery of said substrate; and

     at least one region of read only memory located intermediate a portion of said I/O circuitry and said gate array.

4. The system of Claim 3, wherein said at least one region of read only memory comprises two spaced memory regions having said gate array region located therebetween.

5. The system of Claims 1, 2 or 4, wherein the total number of read only memory cells is from 3 to 100 times the total number of gates in said gate array.

6. The system of Claims 1, 2 or 5, wherein at least one region of said gate array is located adjacent said I/O circuitry and in communication with a portion of said circuitry; and

     at least one region of said read only memory is located centrally with respect to said gate array and in communication with said gate array and a portion of said I/O circuitry.

Fig.1

Fig.2

Fig. 3

0079127

2/3

ROM

SEQUENCE CONTROL UNIT — 48

REGISTER ADDRESS UNIT$_1$ — 46

2 — 46

MEMORY MANAGEMENT UNIT — 43

49

SHIFT NORMALIZE UNIT — 401

ARITHMETIC LOGIC UNIT — 47

INTERRUPT-I/O CONTROL UNIT — 42

45

RAM$_1$ — 44

2 — 44

FRONT PANEL — 40

41

Fig. 4

0079127

**European Patent Office**

## EUROPEAN SEARCH REPORT

EP 82 30 53 14

### DOCUMENTS CONSIDERED TO BE RELEVANT

| Category | Citation of document with indication, where appropriate, of relevant passages | Relevant to claim | CLASSIFICATION OF THE APPLICATION (Int. Cl. ³) |
|---|---|---|---|
| | --- | | G 06 F 9/22 |
| Y | IEEE JOURNAL OF SOLID-STATE CIRCUITS, vol. SC-14, no. 5, October 1979, pages 833-840, New York, USA P.W. COOK et al.: "A study in the use of PLA-based macros" * Page 833, last paragraph - page 834, right-hand column. paragraph 1; page 839, left-hand column, paragraphs 2,3 * | 1,2 | G 06 F 15/C6 H 01 L 27/C2 |
| | --- | | |
| Y | ELECTRONICS INTERNATIONAL, vol. 53, no. 16, July 1980, pages 143,144, New York, USA J.G. POSA: "Microcomputer draws only 3muA" * Whole document * | 1,2 | |
| | --- | | |
| Y | PROCEEDINGS OF THE IEEE, vol. 64, no. 3, March 1976, pages 368,369, New York, USA K. HWANG et al.: "A TTL programmable logic array and its applications" * Page 369, left-hand column, lines 5-10 * | 1 | **TECHNICAL FIELDS SEARCHED (Int Cl. ³)** |
| | --- | | G 06 F H 01 L G 11 C |
| Y | POST OFFICE ELECTRIC ENGIN. JOURNAL, vol. 70, no. 3, October 1977, pages 136-144, London, G.B. J.D. TONGE et al.: "Programmable logic and microprocessors" * Page 138, right-hand column, paragraph 3 * | 1,2 | |
| | ---  -/- | | |

The present search report has been drawn up for all claims

| Place of search THE HAGUE | Date of completion of the search 20-01-1983 | Examiner THOMAES K. |
|---|---|---|

## EUROPEAN SEARCH REPORT

**European Patent Office**

### DOCUMENTS CONSIDERED TO BE RELEVANT

Page 2

| Category | Citation of document with indication where appropriate, of relevant passages | Relevant to claim | CLASSIFICATION OF THE APPLICATION (Int. Cl. 3) |
|---|---|---|---|
| A | US-A-4 057 787 (IBM) <br> * Column 3, lines 5-48 * | 1-3 | |
| A | WESCON CONFERENCE RECORD, vol. 25, September 1981, pages 33/1 - 1 to 7, El Segundo, CA., USA <br> W.K. MILLER: "Registered PROMs" * Pages 33/1 1 to 6 * | 1,2 | |
| A | WESCON CONFERENCE RECORD, vol. 24, 16th-18th September 1980, pages 30/1 1 to 5, Anaheim, CA., USA <br> T. GOODMAN et al.: "Flexible subnanosecond gate array family" * Pages 30/1 1 to 5 * | 3 | |
| A | EP-A-0 041 844 (FUJITSU) <br> * Page 2, lines 2-15 * | 4 | TECHNICAL FIELDS SEARCHED (Int. Cl. 3) |

The present search report has been drawn up for all claims

| Place of search | Date of completion of the search | Examiner |
|---|---|---|
| THE HAGUE | 20-01-1983 | THOMAES K. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82